(19) Europäisches Patentamt

European Patent Office

Office européen des brevets

(11) **EP 1 484 674 B1**

(12) **EUROPEAN PATENT SPECIFICATION**

(45) Date of publication and mention
of the grant of the patent:
**04.10.2006 Bulletin 2006/40**

(51) Int Cl.:
*G06F 7/60* (2006.01)    *H03M 7/00* (2006.01)
*H03L 7/197* (2006.01)    *H03D 13/00* (2006.01)

(21) Application number: **03012840.9**

(22) Date of filing: **06.06.2003**

(54) **Maximally digitized fractional-N frequency synthesizer and modulator with maximal fractional spurious removing**

Maximal digitalisierter Frequenzsynthesizer mit gebrochenem Teilverhältnis und Modulator zur Rauschunterdrückung

Synthétiseur fractionnaire numérisée au maximum et modulateur pour réduction de bruit

(84) Designated Contracting States:
**DE FR GB**

(43) Date of publication of application:
**08.12.2004 Bulletin 2004/50**

(73) Proprietor: **Zhang, Xiaopin**
**81735 München (DE)**

(72) Inventor: **Zhang, Xiaopin**
**81735 München (DE)**

(56) References cited:
**US-A- 6 107 890**        **US-A- 6 160 433**

- **BEARDS R D AND COPELAND M A: "An oversampling Delta-Sigma Frequency Discriminator" IEEE TRANSACTIONS ON CIRCUITS AND SYSTEMS-II, vol. 41, no. 1, January 1994 (1994-01), pages 26-32, XP002258321**
- **BAX W T ET AL: "A SIGMA.DELTA GREQUENCY DISCRIMINATOR BASED SYNTHESIZER" IEEE INTERNATIONAL SYMPOSIUM ON CIRCUITS AND SYSTEMS, 1-3 MAY, NEW ORLEANS, US, NEW YORK, NY, US, 1995, pages 1-4, XP000569231**
- **BAX W T AND COPELAND M A: "A GMSK Modulator using a Delta-Sigma Frequency Discriminator-Based Synthesiser" IEEE JOURNAL OF SOLID-STATE CIRCUITS, vol. 36, no. 8, August 2001 (2001-08), pages 1218-1227, XP002258322**

**Description**

The invention concerns a fractional-N frequency synthesizer for generating a high frequency signal at a frequency that may be a non-integer multiple of its phase-locked-loop reference frequency. If it is necessary, this high frequency signal could also be modulated simultaneously to carry information.

Fractional-N frequency synthesizer has attracted more and more attention in modern electrical technology. It is under intensive research for many years and the progresses such as Delta-Sigma noise shaping technique have been made. However, the problem of fractional spurs is not completely solved and most proposed structures suffer from some inherent constraints, so the application of the fractional-N synthesizer is still limited. It is therefore necessary to search for different techniques that provide new possibilities.

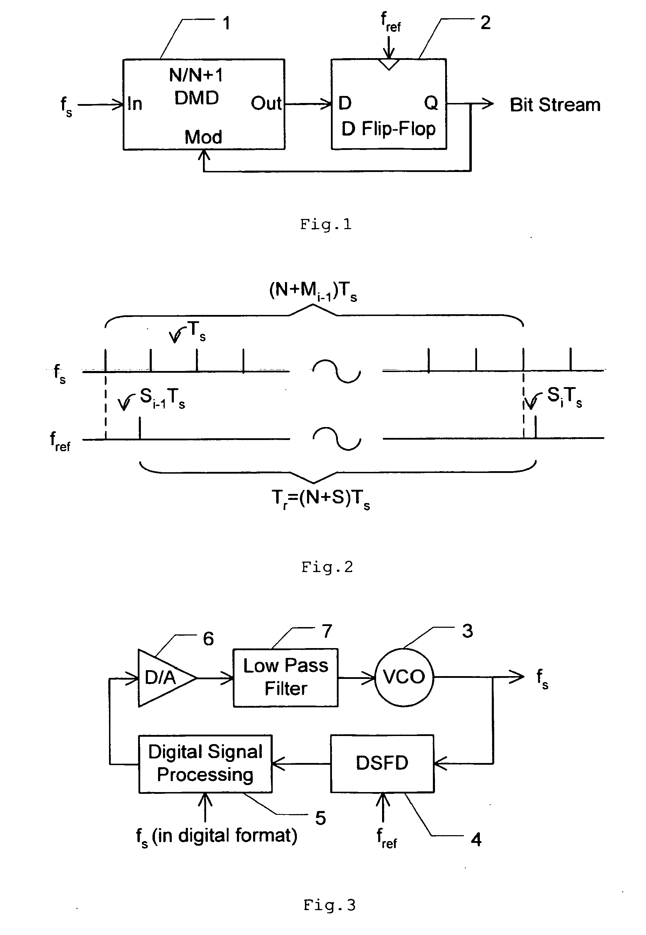

Fig.1 is the structure of the first-order DSFD (Delta-Sigma Frequency Discriminator) (see R. Douglas Beards and Miles A. Copeland, "An Oversampling Delta-Sigma Frequency Discriminator", IEEE Transactions on Circuits and Systems-II: Analog and Digital Signal Processing, Vol. 41, No. 1, January 1994, pp.26-32). The concept of DSFD could be used to construct Fraction-N frequency synthesizers (see Walt T. Bax et. al., "A $\Sigma\Delta$ Frequency Discriminator Based Synthesizer", *IEEE Proc. ISCAS,* Vol. 1, pp. 1-4, Seattle, WA, April 29-May 3, 1995) and modulators (see W. T. Bax and M. A. Copeland, "A GMSK Modulator Using a $\Delta\Sigma$ Frequency Discriminator-Based Synthesizer", IEEE Journal of Solid-State Circuits, Vol. 36, No. 8, August 2001, pp.1218-1227). Unfortunately, it is suggested to used complicated higher-order DSFD to suppress the fractional spurs, which not only is difficult to be made with good quality but also can not greatly increase the suppression ratio to the fractional spurious. In fact, as suggested by this patent, there is another way to almost remove the fractional spurs by using only the first-order DSFD which has a very desirable simple structure.

It is useful to describe the first-order DSFD in more detail for better understanding the present invention.

Refer to Fig.1, if the up-transition from the output of the DMD (Dual Modulus frequency Divider) (1) comes before the reference transition, the output bit will be 1 and the next dividing ratio of the DMD will be set to N+1. On the other hand, if the up-transition from DMD comes after the reference transition, the output bit will be 0 and the next dividing ratio will be N.

Assume $f_s$, the input frequency to the discriminator is:

$$f_s = (N+S) \, f_{ref} \qquad 0 < S < 1 \tag{1}$$

where N is a positive integer, S is a fractional number, and $f_{ref}$ is the reference frequency.

The formula could also be written as:

$$T_{ref} = (N+S) \, T_s \tag{2}$$

in which $T_{ref} = 1/f_{ref}$ and $T_s = 1/f_s$ are the cycle time for reference and input signal respectively.

Fig.2 is the signal time diagram of the frequency discriminator. Assume that at (i-1)'th reference transition the division ratio of the DMD is set to $N+M_{i-1}$ ($M_{i-1}=0$ or 1 which is the output bit of the discriminator). The instantaneous phase of the reference signal relative to the time when the DMD starts to count this $N+M_{i-1}$ cycles is assumed to be $S_{i-1}$ (Normalized with $T_s$, that is, $S_{i-1}$ equals the time difference between these two transitions divided by $T_s$). Note that in the stable state in which the initial transition mismatch between the DMD output and the reference signal is removed, $S_{i-1}$ should be less than 1. The initial mismatch could be removed by letting the discriminator run for enough cycles or resetting the DMD at initial time. After the DMD has counted those $N+M_{i-1}$ cycles, the i'th instantaneous phase will be:

$$S_i = S_{i-1} + (N+S) - (N+M_{i-1}) = S_{i-1} + S - M_{i-1} \tag{3}$$

If $S_i > 0$, then the reference transition will come after the DMD output transition, so $M_i = 1$. Similarly, if $S_i < 0$ the DMD output transition will come after the reference transition, then $M_i = 0$.

Expression (3) is an accumulator function for the first order Delta-Sigma modulation. Note that the instantaneous value $S_i$ is quantized at zero. According to the Delta-Sigma modulation theory, the bit stream $\{M_i\}$ is then the first order one bit Delta-Sigma modulation to the fractional number S. That is, the average value of $\{M_i\}$ will equal to S, so it could be considered as a digital value that is proportional to the fractional number of the input frequency $f_s$. This is why the structure is named as the Delta-Sigma Frequency Discriminator.

As the average value of $\{M_i\}$ equals to S, it seems natural to process the bit stream directly as the detected fractional signal frequency. Since this is a digital signal, the feedback error signal of the synthesizer could be generated by calculating digitally the difference between the required fractional output frequency and this detected fractional frequency, whereas the quantization noise is reduced by decimation and filtering, before or after the error signal generation. However, as the first-order DSFD only performs first order Delta-Sigma modulation, the quantization noise is very high and cannot be sufficiently suppressed by decimation and filtering for most applications. This is why the unpractical higher order Delta-Sigma frequency discriminator is previously proposed.

In fact, decimation and filtering are not the only way to remove the Delta-Sigma quantization noise in the frequency synthesizers. The conventional PLL fractional-N synthesizer using first order Delta-Sigma modulation generates very strong fractional spurious if the quantization noise is only suppressed by loop filtering. But much better performance could be got by adding the analog compensation signal which is generated by using the contents of the Delta-Sigma accumulator to the output of phase detector for canceling the quantization phase noise. However, the performance of such a synthesizer is limited by the precision of the analog circuit which is subject to variations as a function of time and temperature.

The method proposed by this invention is not processing the output bit stream from the DSDF directly as the detected signal frequency, but comparing it bit-by-bit to a bit stream generated by using an accumulator doing first order Delta-Sigma modulation as expression (3) with the fractional number S derived from the required output frequency with respect to the reference frequency as expression (1). It will be shown later that a feedback error signal could be generated by this comparison, and the accuracy of the signal is assured if the content of the accumulator is properly set up after the error signal generation.

The most outstanding benefit of generating the feedback error signal in this way is that the quantization noise contained in the DSFD's output is greatly suppressed by the comparison. Mathematical simulation shows that much better performance is obtained. Also the first order DSFD which has no phase detector and charge pumps is used so that the structure of high frequency circuit is maximally simplified. These advantages provide great potential to reduce the cost and improve the performance of the fractional-N frequency synthesizer.

Fig.3 shows one possible implementation of using DSFD to make a frequency synthesizer. The digital signal processing block (5) will process the bit-stream received from the DSFD (4) together with the required output signal frequency to generate the feedback error signal. It also performs necessary filtering of the error signal to form a suitable loop transfer function. Its output will be sent to a D/A (Digital to Analog Converter) (6) to generate the analogue control voltage for the VCO (Voltage Controlled Oscillator) (3). The low pass filter (7) will only remove the high order sampling harmonics of the D/A and has very small effect on the loop transfer function design.

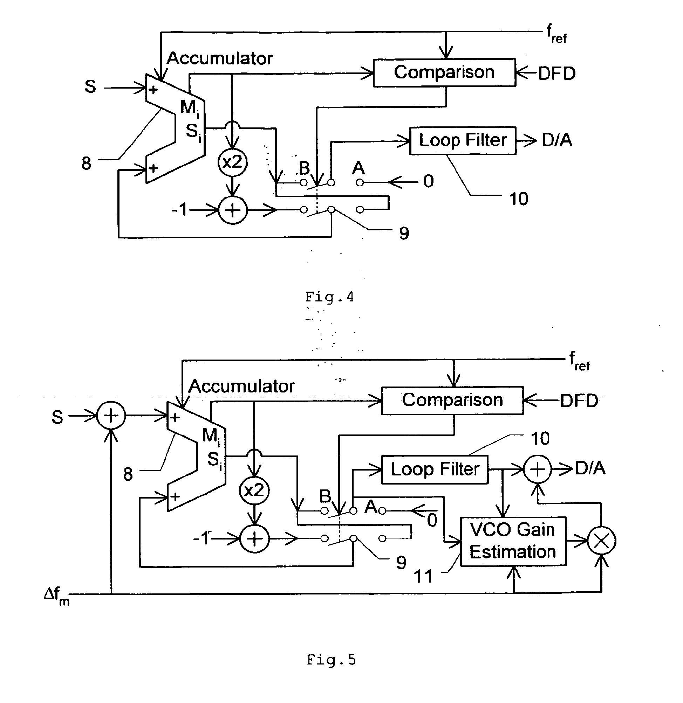

Fig.4 is one possible detailed implementation of the digital signal processing block. The fraction number S is determined by the required output frequency $f_s$ and the reference frequency $f_{ref}$. The block has an accumulator (8) that takes S as input and performs the first order Delta-Sigma modulation. The working sequence of the accumulator is as follows. At i'th reference cycle the accumulator sums its two inputs and subtracts the sum by $M_{i-1}$ to get its next instantaneous value $S_i$. If $S_i$ is larger than zero $M_i$ will be set to 1, otherwise 0. $M_i$ is then compared with the output bit from the DSFD. The comparison result is used to control the feedback error signal generating and the feedback to the accumulator by using the 2x2 switch (9). If the two comparing bits are the same, then the switch will be set to position A, the error signal sent to the loop filter (10) will be 0 and $S_i$ is sent back to the accumulator as the input for next cycle. If the two comparing bits are not the same, the switch will be set to position B, $S_i$ will be sent as the error signal and $2M_i-1$ will be sent back to the accumulator as the input for next cycle.

The explanation to this algorithm is as follows. It is obvious that the output bit stream from the accumulator is equivalent to what is generated by a DSFD with a perfect comparing signal of frequency $f_s$. So if the VCO is oscillating exactly as $f_s$ with the same initial phase, the two comparing bit stream will be the same. According to the above algorithm the feedback error signal is 0 which is correct. If then the oscillation of VCO left the ideal value and developed a large enough phase error relative to $f_s$, the two different comparing bits will appear to indicate the phase error. Although, at this time, the exact value of the difference between the instantaneous phase of the DSFD and the accumulator (8) is not known, it must be larger than the instantaneous phase of the accumulator since the instantaneous phase of the DSFD should have an opposite sigh to that of the accumulator if the comparing bits are not the same.

For the phase detector in the PLL, the perfect feedback error signal at this moment should be the exact instantaneous phase difference between the DSFD and the accumulator (8). But since it is not possible to obtain this exact phase error, it has to be considered whether it is feasible to send the instantaneous phase of the accumulator as the approximated error signal. The answer to this is 'no' if trying to make the detection function as a phase detector. This is because if the contents of the accumulator are used as the error signal continuously for several reference cycles, the detection error may become very large. Since the instantaneous phase of the accumulator is only the lower-limit of the phase error, the detection precision has no guarantee at all.

Fortunately, this difficulty could be solved by making the detection function as a frequency discriminator. The output error signal of the frequency discriminator is the frequency difference between the two comparing signal. Since the product of the frequency difference and the reference cycle time is equal to the phase difference developed in one reference cycle time, the instantaneous phase of the accumulator may also be used as the approximated error signal of the frequency discriminator. What makes the frequency discriminator different to the phase detector is that the frequency discriminator needs to shift the phase of $f_s$ with the developed phase error so that in the next reference cycle only the phase difference developed during that cycle will be measured. Although the operation of shifting the phase of $f_s$ could be done by shifting the instantaneous phase of the accumulator, to do this requires that the developed phase error must be known. Since the developed phase error cannot be precisely known, this requirement at first seems to be an obstacle to the detection. However, further study shows that there is no need to use the precise value of the developed phase error to do the shifting. If a value the same as the approximately detected phase error is used in the shifting, the phase difference between VCO output and $f_s$ in the following detection cycles will contain the undetected part of the developed phase error. This means that the undetected phase error will be accumulated to participate in the following detection. In other words, the partial detection will only change the result by a delay or an overshoot in time. Another key benefit of doing so is that the shifting of the phase of $f_s$ is a self-tracking process. The tracking error of $f_s$ to the VCO output is also the undetected phase error. As long as the undetected phase error is being continually detected by the bit-comparing process, the phase of $f_s$ will follow that of VCO output closely. While the phase of $f_s$ follows that of VCO output closely, the error in the bit-comparing detection will always be kept small. Thus, this detection and tracking cycle ensures that the total phase error calculated by integrating the outputted error signal, which is the instantaneous frequency difference between the two signals, will be accurate except the small delay or overshoot in time.

The performance degradation due to the delay or overshoot is small as long as the reference frequency is high enough compared to the required loop bandwidth. This is verified by the mathematical loop simulation that compares the phase error performance with and without the partial detection.

There is some freedom on what value should be taken as the error signal. Since the lower limit of the developed phase error is the instantaneous phase of the accumulator (8), from statistics point of view it should be optimal to use a value little larger than the instantaneous phase of the accumulator as the error signal. However, the simplest way of implementation is to send the contents of the accumulator as the error signal directly; in most situations this will only cause very little performance degradation. This is performed in Fig.4 where shifting the phase of $f_s$ is done by sending $2M_i-1$ back to the accumulator. The next instantaneous phase of the accumulator will be:

$$S_{i+1} = 2M_i - 1 + S - M_i = M_i - 1 + S \qquad (4)$$

Note that the output bit of the DSFD for the i'th reference cycle is different from that of the accumulator, so if the variables of the DSFD are denoted by apostrophes, the next instantaneous phase of the DSFD will be:

$$S'_{i+1} = S'_i + S - M'_i = S'_i + M_i - 1 + S \qquad (5)$$

Thus the difference of the two instantaneous phases is changed from $S_i - S'_i$ to $-S'_i$, which is the undetected part of the phase error. This means that the phase of $f_s$ is shifted as required.

The gain of the frequency discriminator defined in this way is unity since the instantaneous phase has the same unit as the fractional number S and the actual frequency is proportional to S by a factor of $f_{ref}$, so the difference of the instantaneous phase detected in one reference cycle equals the actual frequency difference.

The performance limitation on this kind of synthesizer comes from the fact that the phase error detection is actually quantized both on detection level and sampling time that is larger than the reference cycle time. A phase error cannot be detected until an output bit from the DSFD is different from the expected value. If the phase error is small then no error will be detected in most of the reference cycles except when the instantaneous phase value is also small. Note that a similar limitation also exists even if the output bit stream of DSFD is directly processed as the detected frequency signal. The following analysis will show what is the quantization level and how to reduce the quantization noise.

The fractional number S can be considered to be a rational number which is less than 1, so it could be expressed as:

$$S = n/m \qquad (6)$$

in which n and m are relatively prime to each other and n<m. If no bit mismatch is detected, the instantaneous phase of the accumulator have a cycle of m values. It is easy to show that these m values are evenly distributed between 0 and 1, and the level interval is l/m. Note that these m values will not appear in sequence according to the magnitude, however, each level will appear once during m reference cycle time. If the instantaneous phase difference is less than l/m, the detected output is always zero. On the other hand, if the phase difference is less than k/m in which k is an integer less than m, the maximum detected phase error will range from k/m to (k-1)/m depending on the way of implementation. So it is clear that the quantization level interval of the phase error detection is $2\pi/m$. More importantly, the minimal phase error of the synthesizer will be solely determined by $2\pi/m$.

Therefore, it is important to properly choose the reference frequency to make m be a large value. Extra care must be taken in a multi channel system to make sure that m is large for every channel. Another requirement is that the reference frequency should be sufficiently higher than the loop bandwidth. Fortunately, the needed high frequency circuit is very simple and most signal processing is done digitally, so that there is often no problem to satisfy the requirement.

One of the flexibilities of using DSFD is that it is possible to form both FLL (Frequency-Locked-Loop) and PLL. The structural difference between forming FLL or PLL by using DSFD is that an additional integral stage at the loop filter input port is needed to form PLL. It is generally considered that the phase noise performance of the PLL is better than FLL, however, it may not be true for the synthesizer of using DSFD. The main noise contribution in such a synthesizer will be that generated by the VCO and the quantization noise of the DSFD, in some designs FLL could have better suppression to these noises than the PLL.

One other flexibility is that digital signal processing is used in most parts of the loop. This makes changing the loop bandwidth easier during the operation. So that it is possible to use a large loop bandwidth at the lock-in stage to greatly reduce the locking time and then switch to a narrower bandwidth during the normal operation to get higher performance. The lock-in time could also be reduced by forming the loop during the lock-in stage as a FLL that has a better transient response than that of the PLL.

One of most important flexibilities of the invented structure is the ability to add frequency or phase modulation to the synthesized high frequency carrier. To do this, no change needs to be made to the high frequency circuit and only the signal processing block in Fig.3 needs to be modified. The required frequency deviation $\Delta f_m$ for the modulation is added to the block as an input. To perform phase modulation, it is needed to differentiate the phase signal to get the frequency deviation. If the loop bandwidth is larger than the modulation bandwidth, the frequency deviation which is normalized by the reference frequency could be simply combined with the fractional number S and sent to the accumulator. This is a type of one point modulation method and its working principal is the same as that of the conventional modulation loop, except with the advantage of digital implementation. The main limitation for this simple method is that at a reasonable reference frequency often the loop bandwidth cannot be wide enough due to the requirement on noise suppression. Fortunately, the structure is especially suitable for using the method of two points modulation to increase the modulation bandwidth.

Fig.5 is one possible implementation of the two points modulation. The modulation signal added to the inputs of the accumulator is the same as that in the one point modulation mentioned previously. Besides, the modulation signal is also combined with the output from the loop filter and applied to the D/A directly. Since this signal is applied after the loop filter, the modulation frequency applied to the VCO could be very high. Note that the modulation applied to the accumulator will make the equivalent comparing signal also contain the required modulation. Thus if the modulation on the VCO is correct, no bit mismatch in the bit stream comparison will be caused by the modulation. This means that the modulation is independent of the loop feedback, so that the loop could still be optimized for the function of frequency synthesizing and its performance is not disturbed by the modulation no matter how strong the low frequency components of the modulation is.

The magnitude of the modulation signal applied directly to the VCO should be properly normalized with respect to the VCO modulation gain coefficient which needs to be calibrated. This could be done before the data burst transmission by locking the loop to several frequency points and getting the required D/A output voltage for these frequencies. Since the loop could get into lock very fast by switching the loop bandwidth and formation, it is possible to do the calibration before every data burst.

If the length of the data burst is very long, then the changing of the VCO modulation gain coefficient with time needs to be compensated. Fig.5 has included a possible compensation method. Assume the modulation transfer function of the VCO is linear, so its output frequency $f_{VCO}$ is determined from the input voltage $V_{in}$ by two parameters: modulation gain coefficient $K_{VCO}$ and base frequency $f_0$.

$$f_{VCO} = K_{VCO} V_{in} + f_0 \qquad\qquad (7)$$

Both changes on $K_{VCO}$ and $f_0$ will cause the bit comparison to output feedback error signal. If the reference frequency is sufficiently high so that the modulation component $\Delta f_m$ is not greatly suppressed in the comparison, then the change on $K_{VCO}$ could be detected by estimating the magnitude of modulation component $\Delta f_m$ in the feedback error signal which is done by the VCO gain estimation block (11) that will also generate the multiplication coefficient to the frequency deviation signal by using the estimated VCO gain. Often the changing of VCO gain is very slow, so the bandwidth of correction feedback could be very small which makes the high precision compensation possible.

**Claims**

1. A fractional-N frequency synthesizer for generating a high frequency signal at a non-integer multiple of the frequency of a reference signal, having a voltage controlled oscillator (3) the output of which is fed to a Delta-Sigma frequency discriminator (4) having a dual modulus frequency divider (1) and a D flip-flop (2), said Delta Sigma frequency discriminator generating a bit stream related to the frequency and phase of said voltage controlled oscillator by using the reference signal, said bit stream then being processed by a digital signal processing block (5) to generate a feedback error signal that represents the frequency difference between a required output frequency and the frequency of said voltage controlled oscillator, said feedback error signal then being filtered by a digital loop filter (10) for providing a required loop transfer function and subsequently being converted by a digital to analog converter (6) to an analogue control voltage which is fed back via an analogue low pass filter (7) to said voltage controlled oscillator to form a loop for controlling the frequency of said voltage controlled oscillator, **characterized in that** said feedback error signal is generated by comparing bit by bit in said digital signal processing block (5) said bit stream from said Delta-Sigma frequency discriminator to a second bit stream from an accumulator (8) that digitally performs first order Delta Sigma modulation and which has an input a fractional number S derived from the required output frequency with respect to the reference frequency, whereby said comparing bit-by-bit indicates a phase error between the said VCO output and an ideal reference signal as represented by an output of said accumulator (8), the phase of said ideal reference signal being shifted to closely track the phase of said VCO output by shifting the contents of said accumulator (8) with a value derived from said contents when the two comparing bits of said comparing bit-by-bit are not the same, thus allowing the value of said feedback error signal to be evaluated with a controllable error.

2. A frequency synthesizer as claimed in claim 1, **characterized in that** when said two comparing bits are not the same then said feedback error signal for the reference cycle will be set as the current value of said accumulator while the feedback value to said accumulator for the next cycle will be changed from its current value to two times of its current output bit minus one.

3. A frequency synthesizer as claimed in claim 1 or claim 2, **characterized in that** said fractional number S is chosen with a suitable reference frequency by using the design principle that non-reducible denominator of said fractional number S should be larger than a value that determines the minimal phase error performance of the synthesizer.

4. A frequency synthesizer as claimed in claim 1, claim 2, or claim 3, **characterized in that** said digital loop filter has an additional integrator at its input.

5. A frequency synthesizer as claimed in claim 1, claim 2, or claim 3, **characterized in that** the loop is formed to be a frequency-locked-loop in order to optimize its noise performance and transient response characteristics.

6. A frequency synthesizer as claimed in any one of the above claims, **characterized in that** its loop bandwidth, and the loop formation as either a phase-locked-loop or as a frequency-locked-loop, could be changed during the operation digitally to get fast lock-in time at start up and high performance in normal working stage.

7. A frequency or phase modulator that is based on the frequency synthesizer as claimed in any one of the above claims, **characterized in that** a required normalized frequency deviation signal is combined with said fractional number S and sent to said accumulator to perform the modulation.

8. A frequency or phase modulator as claimed in claim 7, **characterized in that** said required normalized frequency deviation signal is also combined with the output from said digital loop filter and applied to said digital to analogue converter to perform wideband modulation.

9. A frequency or phase modulator as claimed in claim 8, **characterized in that** the gain of said voltage controlled oscillator is calibrated by locking the loop to several frequency points to get the required output voltage from said digital to analogue converter for these frequencies, the calibration time being reduced by switching the loop bandwidth.

10. A frequency or phase modulator as claimed in claim 8, or 9, **characterized in that** the change on the gain of said voltage controlled oscillator could be compensated during the normal operation by estimating the magnitude of modulation component in the feedback error signal.

**Patentansprüche**

1. Fraktional-N Frequenzsynthesizer zur Erzeugung eines hohen Frequenzsignals, dessen Frequenz einem nicht ganzzahligen Vielfachen der Frequenz des Referenzsignals entspricht, mit einem spannungsgesteuerten Oszillator (3), dessen Ausgangsignal einem aus einem Zwei-Modulus-Frequenzteiler (1) und einem D Flipflop bestehenden Delta-Sigma Frequenzdiscriminator (4) zugeführt wird, an dessen Ausgang durch die Auswirkung des Referenzsignals ein aus der Frequenz und Phase des spannungsgesteuerten Oszillators ergebender Bitstrom ausgegeben wird, welcher durch einen digitalen Signal-Verarbeitungsblock (5) zur Erzeugung eines rückgekoppelten Korrektursignals verarbeitet wird, wobei das rückgekoppelte Korrektursignal die Frequenzdifferenz zwischen der geforderten Frequenz des Ausgangsignals und der Frequenz des spannungsgesteuerten Oszillators repräsentiert, einen digitalen Schleifenfilter (10) durchläuft, in ein analoges Steuersignal durch einen Digatal-Analog-Wandler (6) umgesetzt wird, weiter einen analogen Tiefpassfilter (7) durchläuft und zur Bildung einer Schleife zur Steuerung der Frequenz des spannungsgesteuerten Oszillators zurück zum spannungsgesteuerten Oszillator geführt wird, **dadurch gekennzeichnet, daß** das rückgekoppelte Korrektursignal sich aus einem in dem digitalen Signal-Verarbeitungsblock (5) durchgeführten Bitvergleich ergibt, in welchem der Bitstrom von dem Delta-Sigma Frequenzdiscriminator mit dem Bitstrom vom Akkumulator (8) verglichen wird, über welchen eine digitale Delta-Sigma Modulation erster Ordnung vorgenommen wird und welchem eine von der geforderten Ausgangfrequenz und der Referenzfrequenz abgeleitete fraktionale Zahl S eingespeist wird, wobei die Bitdifferenz der Phasendifferenz zwischen dem Ausgangsignal des spannungsgesteuerten Oszillators und einem durch einen Ausgang des Akkumulators (8) repräsentierten Sollreferenzsignal entspricht; wenn diese Bitdifferenz ungleich Null ist, kann die Phase des Ausgangsignals des spannungsgesteuerten Oszillators durch eine, mittels Änderung des Werts des Akkumulators (8) realisierte, Veränderung der Phase des Sollreferenzsignals ummittelbar verfolgt werden und damit das rückgekoppelte Korrektursignal mit einer steuerbaren Abweichung ermittelt werden.

2. Frequenzsynthesizer nach Anspruch 1, **dadurch gekennzeichnet, daß** wenn die Bitdifferenz ungleich Null ist, das rückgekoppelte Korrektursignal für die Referenzperiode auf den gegenwärtigen Wert des Akkumulators eingestellt wird, wobei der rückgekoppelte Wert des Akkumulators für die nächste Periode von seinem gegenwärtigen Wert zum Zweifachen seines gegenwärtigen Werts minus 1 geändert wird.

3. Frequenzsynthesizer nach Anspruch 1 oder 2, **dadurch gekennzeichnet, daß** eine fraktionale Zahl S nach einer Entwurfsgrundlage gemäß einer geeigneten Referenzfrequenz so ausgewählt wird, daß der nicht reduzierbare Divisor der fraktionalen Zahl S größer als ein Wert sein sollte, welcher das minimale Phasenrauschen des Frequenzsynthesizers bestimmt.

4. Frequenzsynthesizer nach Anspruch 1, 2 oder 3, **dadurch gekennzeichnet, daß** am Eingang des digitalen Schleifenfilters einen zusätzliche Integrator vorgesehen wird.

5. Frequenzsynthesizer nach Anspruch 1, 2 oder 3, **dadurch gekennzeichnet, daß** die Schleife eine Frequenz-Locked Loop ist, um das Rauschverhalten und die dynamische Reaktionscharakteristik zu optimieren.

6. Frequenzsynthesizer nach einem der vorhergehenden Ansprüche, **dadurch gekennzeichnet, daß** die Bandbreite der Schleife und der Aufbau der Schleife, entweder als Phase-Locked Loop oder als Frequenz-Locked Loop, im Betrieb digital geändert werden kann, um eine kurze Einschwingzeit nach dem Einschalten und eine bessere Performanz im normalen Betrieb zu erzielen.

7. Frequenzmodulator oder Phasenmodulator, welcher auf einen Frequenzsynthesizer nach einem der vorhergehenden Ansprüche basiert, **dadurch gekennzeichnet, daß** ein gefordertes normalisiertes Frequenzabweichungssignal mit der fraktionalen Zahl S addiert und dann dem Akkumulator zugeführt wird, um eine Modulation vorzunehmen.

8. Frequenzmodulator oder Phasenmodulator nach Anspruch 7, **dadurch gekennzeichnet, daß** das geforderte normalisierte Frequenzabweichungssignal mit dem Ausgangsignal des digitalen Schleifenfilters addiert und dann dem Digital-Analog-Wandler zugeleitet wird, um eine breitbandige Modulation vorzunehmen.

**9.** Frequenzmodulator oder Phasenmodulator nach Anspruch 8, **dadurch gekennzeichnet, daß** die Verstärkung des spannungsgesteuerten Oszillators **dadurch** kalibriert wird, daß die Schleife zu einigen Frequenzen eingeschwungen wird, um die geforderten Ausgangsspannungen des Digital-Analog-Wandlers zu erhalten, welche den eingeschwungenen Frequenzen entsprechen, wobei die Kalibrierungsdauer durch die Umschaltung der Bandbreite der Schleife verkürzt wird.

**10.** Frequenzmodulator oder Phasenmodulator nach Anspruch 8 oder 9, **dadurch gekennzeichnet, daß** die Veränderung der Verstärkung des spannungsgesteuerten Oszillators **dadurch** kompensiert wird, daß die Amplitude des Modulationsanteils beim rückgekoppelten Korrektursignal im normalen Betrieb geschätzt wird.

**Revendications**

**1.** c'est une sorte de fractionalle-N fréquence synthetiseur pour produire une haute fréquence signal en un (non) interger multiple de fréquence de un référence signal, ayant un oscilateur contrôlé en tension (3), le sortie de quel est fourni à un Delta-Sigma fréquence discriminateur (4) ayant un double module fréquence diviseur (1), et un flip-flop (2) dit Delta-Sigma fréquence discriminateur produitant bit stream, alors lier avec fréquence et phase d'oscilateur contrôlé en tension (VCO) par utilant le référence signal , dit bit stream, alors étant processé par un processant bloc numérique (5) à produire un feedback erreur signal ce que représent le différence de fréquence entre un fréquence de requis rendement et le fréquence de dire oscilateur contrôlé en tension, dit feedback erreur signal alors étant filtré par un boucle filtre numérique (10) pour fornir un demendé boucle transfer fonction et par la suite de convertir d'un numérique à l'analogue à un analoque controlé en tension le quel is feedback via un l'analogue basse-passe filtre (7) dit oscilateur contrôlé en tension à formé un boucle pour contrôler le fréquence de dit oscillateur contrôlé en tension, caractérisé dans le quel dit feedback erreur signale est prend de lieur par bit par bit indicate un phase erreur entre le dit sortie de VCO et un idéal référance signale étant shifté à férmé trace le phase de dit VCO sortie par shiftant contente de dit accumulateur (8) avec un valeur dériver de dit comtentes quand les deux comparants bits de dit comparant bit par bit ne sont pas de même, ainsi permttant de valeur de dit feedback erreur signale evaluaté avec un contrôllable erreur.

**2.** Un fréquence synthetiseur comme de déclarer dans le décleration 1, **caractérisé** dans que quand dit deux comparant bits ne sont pas de même alors dit feedback erreur signal pour le référence cycle mettera comme le courant valeur de dit accumulateur pendant que le feedback valeur à dit accumulateur pour le suivant cycle sont changé de son courant valeur à deux fois de son courant sortie bit moins un.

**3.** Un fréquence synthetiseur comme de déclarer dans le décleration 1 ou décleration 2, **caractérisé en** le quel dit fractionalle number S est choisi avec un convient référance fréquence par utilisant le désign principle que non-réductible dénominateur de dit fractionale number S devrait être plus greand que un valeur que détermines le minimal phase erreur performance de synthétiser.

**4.** Un fréquence synthétiseur comme de déclarer dans le décleration 1, décleration 2, ou décleration 3, **caractérisé en** le quel dit blouc filtre numérique a un additional intergrateur en son entre.

**5.** Un fréquence synthétiseur comme de déclarer dans le décleration 1, décleration 2, ou décleration 3, **caractérisé** dans le boucle est formé étant un boucle à fréquence-verrouillage afin de optimise son bruit performance et transient résponse caractéristiques.

**6.** Un fréquence synthétiseur comme de déclarer dans qulqu'un de décleration au-dessus, **caractérisé** dans son bande passante de boucle et le boucle formation comme un fréquence-vérrouillage-boucle ou l'autre fréquence-vérrouillage-boucle peut être changé pendant le operation numérique à obtenir rapide enfermer temps en déclancher et haute performance en normal marche étape.

**7.** Un fréquence ou phase modulateur qui est basé en le fréquence synthéseur comme déclarer en un déclaration au-déssus, **caractérisé en que** un requisé normalisé fréquence déviation signal est combiné avec dit fractionalle nombre S et envoyé à dit accumulateur à exécuter la modulation.

8. Un fréquence ou phase modurateur comme déclarer en la déclaration 7, **caractérisé en que** dit requisé normalisé fréquence déviation signal est aussi combiné avec le sortie de dit une boucle filtre numérique et s'appliquer à dit numérique à analogue converteur à exécuter large -bande moduration.

9. Un fréquence ou phase modulateur comme déclarer en la déclaration 8, **caractérisé en que** dit le gain de dit requisé normalisé fréquence déviation signal est aussi combiné avec l'oscilateur contrôlé en tension (VCO) est calibraté par vérroaillge le boucle à plusieurs fréquence points à l'obtenir réquis sortie voltage de dit numérique à analogue converteur pour ces frénquences, le temps de calibration étant réduire par interrupteur le boucle bande-passant.

10. Un fréquence ou phase modurateur comme déclarer en le déclaration 8 ou 9, **caractérisé en que** le changement dans le gain de dit l'oscillateur contrôllé par tension est compensé pendant normale opération par estimation de le magnitude de component de modulation dans le feedback erreur signal.

Fig.1

Fig.2

Fig.3

Fig.4

Fig.5